# EUROPEAN PATENT APPLICATION

(11) **EP 4 835 568 A1**
(43) Date of publication of application: **04.11.2026**
(21) Application number: 25173651.8
(22) Date of filing: 30.04.2025
(51) Int. Cl.: G03F 7/00

(54) **SUBSTRATE STAGE AND EXPOSURE APPARATUS**

(71) Applicant: ASML Netherlands B.V., 5500 AH Veldhoven (NL)
(72) Inventor: ROSET, Bas, Johannes, Petrus, 5500 AH Veldhoven (NL); OCKENFELS, Simon, 5500 AH Veldhoven (NL)
(74) Representative: ASML Netherlands B.V.

(57) **Abstract**

A substrate stage configured to position a substrate, the substrate stage comprises a substrate support configured to support the substrate, a short stroke actuator configured to position the substrate support, and a long stroke actuator configured to position the short stroke actuator and the substrate support. The substrate stage further comprises a controller configured to control the short stroke actuator according to a short stroke setpoint and to control a relative position of the long stroke actuator according to a relative position setpoint forming a difference between the short stroke setpoint of the short stroke actuator and a long stroke setpoint of the long stroke actuator. The controller is further configured to determine a feedforward signal from the relative position setpoint, and to feed the feedforward signal to the short stroke actuator.

## Description

### FIELD

The present invention relates to a substrate stage configured to position a substrate and to an exposure apparatus comprising said substrate stage.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

In semiconductor device manufacturing processes, apparatuses can be used to process and/or assess objects such as a substrate or a patterning device. An example of such an apparatus is an exposure apparatus used to generate interactions between a radiation, for example an electromagnetic radiation or a charged-particle radiation, with a substrate. Other examples of such apparatuses are a deposition apparatus, an etching apparatus, and a die-bonding apparatus. A lithographic apparatus and an assessment apparatus are examples of an exposure apparatus. A lithographic apparatus may use an electromagnetic radiation or a charged-particle radiation to form a pattern onto a layer of radiation-sensitive material, for example a layer of photo resist, provided on a substrate. Examples of a lithographic apparatus are a deep ultraviolet (DUV) lithographic apparatus and an extreme ultraviolet (EUV) lithographic apparatus. An assessment apparatus may form interaction products resulting from interaction of an electromagnetic radiation or charged-particle radiation with an object such as a substrate or a patterning device. An inspection apparatus and a metrology apparatus are examples of such assessment apparatuses and may be used to detect particles or measure a critical dimension, for example.

The substrate may be supported by a support, such as a substrate table, which may be positioned by a positioner. The positioner that is configured to position the support may comprise a long-stroke actuator and a short-stroke actuator. The short-stroke actuator may be arranged to move the substrate support WT relative to the long-stroke actuator with a high accuracy over a small range of movement.

In semiconductor manufacturing, it is desirable to enhance a yield in terms of processed number of substrates (e.g. wafers) per hour, which may require faster accelerations, hence higher forces to be exerted by he positioner on the support. On the other hand, a reduction of power consumption is desired. In order to achieve such combination of high acceleration and relatively low power consumption, use may be made of the so called lagging long stroke concept. In this concept, the relatively high mass long stroke module accelerates and decelerates at a lower pace with regard to the lower mass short stroke module. The larger the allowable relative motion range of the short stroke module relative to the long stroke module, the more energy may be saved.

The relative motion of the short stroke module in respect of the long stroke module may result in more disturbances on the short stroke module, hence on the support, due to hoses and flexures interconnecting the long stroke module and the short stroke module, acoustic coupling between the short stroke module and the long stroke module, and parasitic effects of a gravity compensator of the support, in that, for example, a force exerted by the gravity compensator on the support may change as the short stroke module moves in respect of the long stroke module.

### SUMMARY

Considering the above, it is an object of the invention to enhance an acceleration of the support, while keeping disturbance force on the support low.

According to an embodiment of the invention, there is provided a substrate stage configured to position a substrate, the substrate stage comprising:
- a substrate support configured to support the substrate
- a short stroke actuator configured to position the substrate support,
- a long stroke actuator configured to position the short stroke actuator and the substrate support, and
- a controller configured to control the short stroke actuator according to a short stroke setpoint and to control a relative position of the long stroke actuator according to a relative position setpoint forming a difference between the short stroke setpoint of the short stroke actuator and a long stroke setpoint of the long stroke actuator, wherein the controller is further configured to determine a feedforward signal from the relative position setpoint, and to feed the feedforward signal to the short stroke actuator.

According to a further embodiment of the invention, there is provided a substrate stage configured to position a substrate, the substrate stage comprising:
- a substrate support configured to support the substrate
- a short stroke actuator configured to position the substrate support,
- a long stroke actuator configured to position the short stroke actuator and the substrate support, and
- a controller configured to control the short stroke actuator according to a short stroke setpoint and to control a relative positon of the long stroke actuator according to a relative position setpoint forming a difference between the short stroke setpoint of the short stroke actuator and a long stroke setpoint of the long stroke actuator, wherein the controller is further configured to generate a position path correction signal fromthe relative position setpoint, and to add the position path correction signal to a measured position of the short stroke actuator.

According to a yet further embodiment of the invention, there is provided a substrate stage configured to position a substrate, the substrate stage comprising:
- a substrate support configured to support the substrate
- a short stroke actuator configured to position the substrate support,
- a long stroke actuator configured to position the short stroke actuator and the substrate support, and
- a controller configured to control the short stroke actuator according to a short stroke setpoint and to control a relative position of the long stroke actuator according to a relative position setpoint forming a difference between the short stroke setpoint of the short stroke actuator and a long stroke setpoint of the long stroke actuator, wherein the controller is further configured to apply a delay compensation to the relative position setpoint, wherein the controller comprises a long stroke actuator control loop and wherein the controller is configured to input the delay compensated relative position setpoint to the long stroke actuator control loop.

According to a still further embodiment of the invention, there is provided an exposure apparatus comprising said substrate stage.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus according to an embodiment of the invention;
- Figure 2 depicts a detailed view of a part of the lithographic apparatus of Figure 1;
- Figure 3 schematically depicts a position control system as part of a positioning system according to an embodiment of the invention;
- Figure 4 schematically depicts a control diagram of a controller as part of a positioning system according to an embodiment of the invention;
- Figure 5 schematically depicts a part of the controller according to Figure 4;
- Figure 6 depicts a calibration curve as may be employed in the controller according to Figure 4;
- Figure 7 schematically depicts a part of the controller according to Figure 4 and which may employ the calibration curve according to Figure 6; and
- Figure 8 depicts time diagrams of controller error, interest to controller error and internal force based on which a performance of the controller according to Figure 4 will be explained.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

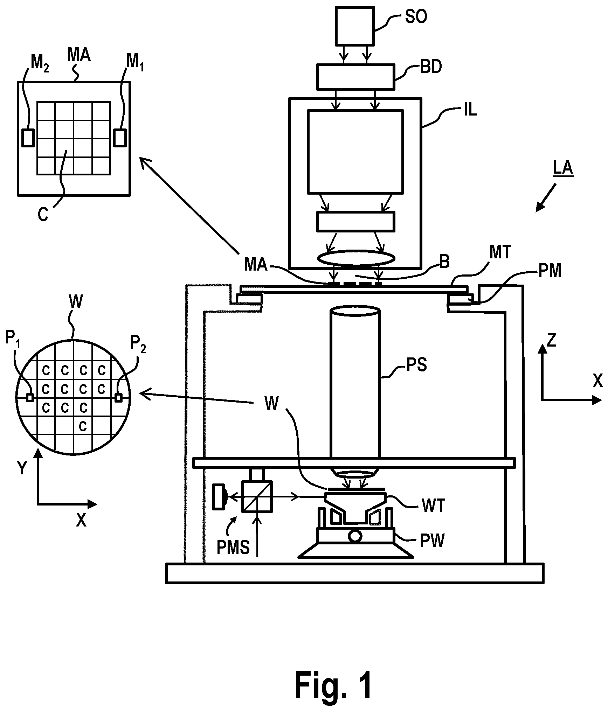

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

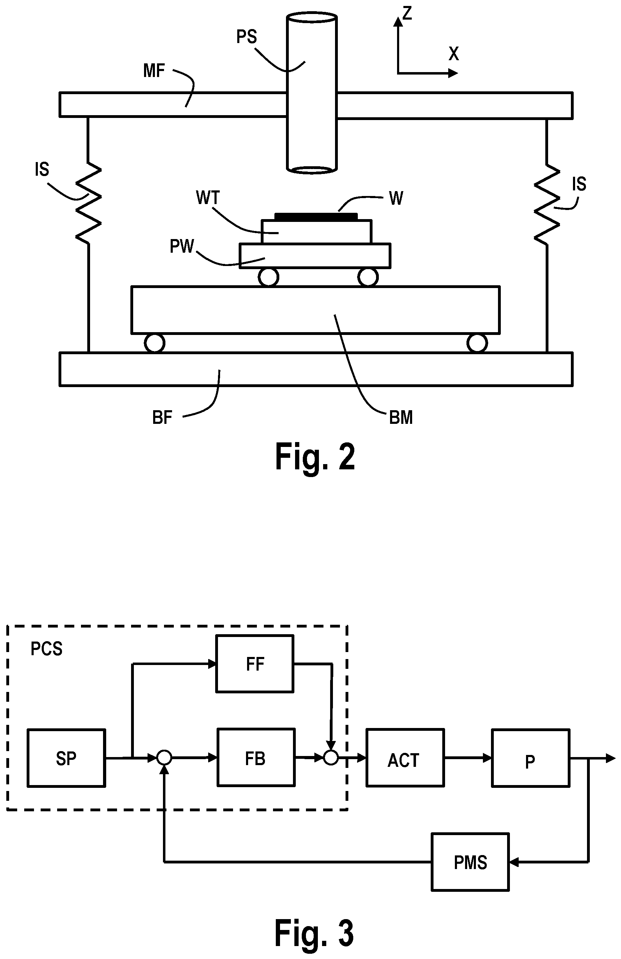

Figure 2 shows a more detailed view of a part of the lithographic apparatus LA of Figure 1. The lithographic apparatus LA may be provided with a base frame BF, a balance mass BM, a metrology frame MF and a vibration isolation system IS. The metrology frame MF supports the projection system PS. Additionally, the metrology frame MF may support a part of the position measurement system PMS. The metrology frame MF is supported by the base frame BF via the vibration isolation system IS. The vibration isolation system IS is arranged to prevent or reduce vibrations from propagating from the base frame BF to the metrology frame MF.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor, a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.

The position measurement system PMS may comprise an encoder system. An encoder system is known from for example, United States patent application US2007/0058173A1, filed on September 7, 2006, hereby incorporated by reference. The encoder system comprises an encoder head, a grating and a sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example, +1^{st} order, -1^{st} order, +2^{nd} order and -2^{nd} order. The encoder system optically combines the primary radiation beam and the secondary radiation beam into a combined radiation beam. A sensor in the encoder head determines a phase or phase difference of the combined radiation beam. The sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads is arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998, hereby incorporated by reference. The interferometer system may comprise a beam splitter, a mirror, a reference mirror and a sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

The first positioner PM may comprise a long-stroke module and a short-stroke module. The short-stroke module is arranged to move the mask support MT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the first positioner PM is able to move the mask support MT relative to the projection system PS with a high accuracy over a large range of movement. Similarly, the second positioner PW may comprise a long-stroke module and a short-stroke module. The short-stroke module is arranged to move the substrate support WT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the second positioner PW is able to move the substrate support WT relative to the projection system PS with a high accuracy over a large range of movement.

The first positioner PM and the second positioner PW each are provided with an actuator to move respectively the mask support MT and the substrate support WT. The actuator may be a linear actuator to provide a driving force along a single axis, for example the y-axis. Multiple linear actuators may be applied to provide driving forces along multiple axis. The actuator may be a planar actuator to provide a driving force along multiple axis. For example, the planar actuator may be arranged to move the substrate support WT in 6 degrees of freedom. The actuator may be an electromagnetic actuator comprising at least one coil and at least one magnet. The actuator is arranged to move the at least one coil relative to the at least one magnet by applying an electrical current to the at least one coil. The actuator may be a moving-magnet type actuator, which has the at least one magnet coupled to the substrate support WT respectively to the mask support MT. The actuator may be a moving-coil type actuator which has the at least one coil coupled to the substrate support WT respectively to the mask support MT. The actuator may be a voice-coil actuator, a reluctance actuator, a Lorentz-actuator or a piezo-actuator, or any other suitable actuator.
The lithographic apparatus LA comprises a position control system PCS as schematically depicted in Figure 3. The position control system PCS comprises a setpoint generator SP, a feedforward controller FF and a feedback controller FB. The position control system PCS provides a drive signal to the actuator ACT. The actuator ACT may be the actuator of the first positioner PM or the second positioner PW. The actuator ACT drives the plant P, which may comprise the substrate support WT or the mask support MT. An output of the plant P is a position quantity such as position or velocity or acceleration. The position quantity is measured with the position measurement system PMS. The position measurement system PMS generates a signal, which is a position signal representative of the position quantity of the plant P. The setpoint generator SP generates a signal, which is a reference signal representative of a desired position quantity of the plant P. For example, the reference signal represents a desired trajectory of the substrate support WT. A difference between the reference signal and the position signal forms an input for the feedback controller FB. Based on the input, the feedback controller FB provides at least part of the drive signal for the actuator ACT. The reference signal may form an input for the feedforward controller FF. Based on the input, the feedforward controller FF provides at least part of the drive signal for the actuator ACT. The feedforward FF may make use of information about dynamical characteristics of the plant P, such as mass, stiffness, resonance modes and eigenfrequencies.

As explained above, the second positioner that is configured to position the support, may comprise a long-stroke actuator and a short-stroke actuator. The short-stroke actuator is arranged to move the substrate support WT relative to the long-stroke actuator with a high accuracy over a small range of movement. The long-stroke actuator is arranged to move the short-stroke actuator relative to the projection system PS with a relatively low accuracy over a large range of movement. The long stroke actuator may be referred to as a long stroke, LoS, or long stroke module and the short stroke actuator may be referred to as a short stroke, SS, or short stroke module. The substrate support and a movable part of the short stroke actuator may be immediately connected to each other, or may be one.

A controller controls the long stroke actuator and the short stroke actuator. A short stroke controller is provided with a short stroke controller error signal formed by a difference between a short stroke setpoint and a short stroke position as measured by a short stroke position sensor. An output signal of the short stroke controller is provided as a force signal to the short stroke actuator. A long stroke controller is provided with a long stroke error signal formed by a position difference between a measured short stroke position and a measured long stroke position as measured by respective short stroke and long stroke position sensors. An output signal of the long stroke controller is provided as a force signal to the long stroke actuator.

For the exposure apparatus, a requirement on energy consumption may become more strict. At the same time, a throughput demand may be increasing. To keep up with increasing throughput demands, while at the same time reduce energy consumption, a so far promising concept is a so-called Lagging long stroke concept. In this concept the relative high in mass long stroke module accelerates and decelerates at a lower pace w.r.t. the lighter in mass short stroke module and substrate support. The relative distance between the short stroke module and the long stroke module might change during a scanning and/or step movement. Depending on the allowable long stroke module towards short stroke module relative motion range, a substantial amount of energy saving may be realized.

With the lagging long stroke control strategy, the above described controller may be modified in that a relative position setpoint is added to the position difference between a measured short stroke position and a measured long stroke position, the sum of the relative position setpoint and the position difference between the measured short stroke position and the measured long stroke position being input as long stroke controller error signal to the long stroke controller.

The short stroke setpoint may be defined as a setpoint representing an absolute position of the short stroke. The relative position position setpoint may define a relative position of the long stroke in respect of the short stroke, or vice versa. The relative position position setpoint may form a difference between a long stroke position setpoint representing an absolute position of the long stroke and the short stroke position setpoint.

Although the long stroke actuator acceleration setpoint levels and high frequent excitation contents may be reduced, the relative long stroke module towards short stroke module motion however may be increasing in the lagging long stroke scenario. The latter may pose challenges in realizing sufficiently low coupling between long stroke module and short stroke module to keep the disturbance forces on the short stroke module and the substrate support sufficiently low. A challenge in this endeavor may found in a short stroke actuator-Z actuator design with its integrated magnetic gravity compensator and a parasitic damping and stiffness in the short stroke actuator-XY actuator.

A performance of the substrate support position control may be expressed in terms of a point of interest error IE. The point of interest error may be defined as an error in the position of the point of interest. The point of interest may typically correspond to a point of the substrate that is intended to be accurately positioned with regard to a given setpoint of the short stroke actuator. The point of interest error may deviate from a controller error of a controller of the short stroke module, due to e.g. structural deformations of the short stroke module. For example, a position measurement of the short stroke module (e.g. an encoder position measurement) may exhibit deviations due to structural deformations of the short stroke module.

A main servo performance requirement may be on point of interest error *IE* of the SS. However, substrate support WT performance specifications may relate to two other key performance indicators, KPI's, related to *IE.* That is, the Controller Error *CE_{SS}* of the short stroke module controller and the so-called Interest to Controller Error, i.e. *ICE.* The Controller Error of the short stroke module may be defined as an error signal in the short stroke module controller, i.e. a difference between the short stroke setpoint and the measured position of the substrate support, i.e. the measured position of the short stroke module. The Interest to Controller Error may be defined as a deviation between the Controller Error and Point of Interest Error, that is *ICE = CE_{SS} - IE,* or *ICE = z - yₛₛ,* where z equals the point of interest and *yₛₛ* equals the measured short stroke module position which is used as feedback signal in the short stroke controller. An important aspect that the *ICE* KPI may capture is e.g. structural deformation present in the short stroke module due to e.g. local disturbance forces acting on the short stroke module.

In general, a physical coupling between the long stroke module and the short stroke module may be due to the following causes:

Hoses and flexures between the long stroke module and the short stroke module may supply vacuum e.g. used in vacuum clamping of the substrate and electrical power for powering e.g. sensors on the short stroke module.

Acoustic coupling between the long stroke module and the short stroke module. Due to relative motion of the long stroke module in respect of the short stroke module and/or due to long stroke module vibrations, disturbance forces may be transmitted to the short stroke module, in particular in case of air or other gas between the long stroke module and the short stroke module.

Parasitic effects of the short stroke actuator may impose stiffness and damping coupling between the long stroke module and the short stroke module. The short stroke actuator may comprise a magnetic gravity compensator to compensate gravitation forces on the short stroke module and the substrate support. The magnetic gravity compensation may be implemented by a ring magnet on the long stroke side surrounding a ring magnet on the short stroke side. Due to relative movement of the short stroke module in respect of the long stroke module, a concentricity of the ring magnets may be affected, which may result in a change in the vertical force and/or a torque on the short stroke magnet. Furthermore, damping may result from e.g. Eddy currents in cooling plates that separate a cooling fluid from the short stroke actuator actuator coils.

As a result, of the coupling due to hoses and flexures, the acoustic coupling, the actuator parasitic effects and the damping coupling described above, the interest error IE and the interest to controller error ICE of the substrate stage may increase, as the relative motion of the short stroke module relative to the long stroke module increases.

The present developments seeks to enhance an accuracy of the position of the substrate support at a large relative motion of the short stroke module in respect of the long stroke module, which may facilitate the lagging long stroke concept.

The present document proposes three developments that may be used as such or in combination, to enhance the accuracy of the position of the substrate support at a large relative motion of the short stroke module in respect of the long stroke module. The three developments are discussed one by one in the below.

According to an aspect, there is provided a substrate stage configured to position a substrate, the substrate stage comprising:
- a substrate support configured to support the substrate
- a short stroke actuator configured to position the substrate support,
- a long stroke actuator configured to position the short stroke actuator and the substrate support, and
- a controller configured to control the short stroke actuator according to a short stroke setpoint and to control a relative position of the long stroke actuator according to a relative position setpoint forming a difference between the short stroke setpoint of the short stroke actuator and a long stroke setpoint of the long stroke actuator, wherein the controller is further configured to determine a feedforward signal from the relative position setpoint, and to feed the feedforward signal to the short stroke actuator.

With the lagging long stroke control strategy, the setpoint of the long stroke actuator differs from the setpoint of the short stroke actuator. A feedforward signal is derived from said difference, i.e. said relative setpoint, the feedforward signal being fed to the short stroke actuator. The relative position setpoint may be representative of the difference between the long stroke position setpoint and the short stroke position setpoint, representing a relative motion between the long stroke actuator and the short stroke actuator, i.e. a relative motion between the long stroke module and the short stroke module. An effect of actuator stiffness, actuator damping and/or stiffness of hoses between the long stroke module and the short stroke module may be mitigated in that the feedforward signal is derived from the relative position setpoint, and in that the feedforward signal is fed to the short stroke actuator. As the feedforward signal is derived from the short stroke actuator and long stroke actuator setpoints instead of from measured positions, sensor delay and sensor noise, which may adversely affect an effect of the feedforward, may be avoided. Moreover, errors in the measurement of the short stroke position and/or long stroke position, e.g. as a result of short stroke module deformation, may be avoided from adversely affecting an effect of the feedforward.

In an embodiment, stiffness may be taken into account in that the short stroke setpoint and the relative position setpoint comprise position setpoints and in that the controller is configured to determine the feedforward signal by multiplying the relative position setpoint by a stiffness matrix.

The stiffness matrix may represent stiffness related forces induced on the short stroke module via movement of the long stroke module.

In an embodiment, damping may be taken into account in that the short stroke setpoint and the relative position setpoint comprise velocity setpoints and in that the controller is configured to determine the feedforward signal by multiplying the relative position setpoint by a damping matrix.

The damping matrix may represent damping related forces induced on the short stroke module via movement of the long stroke module.

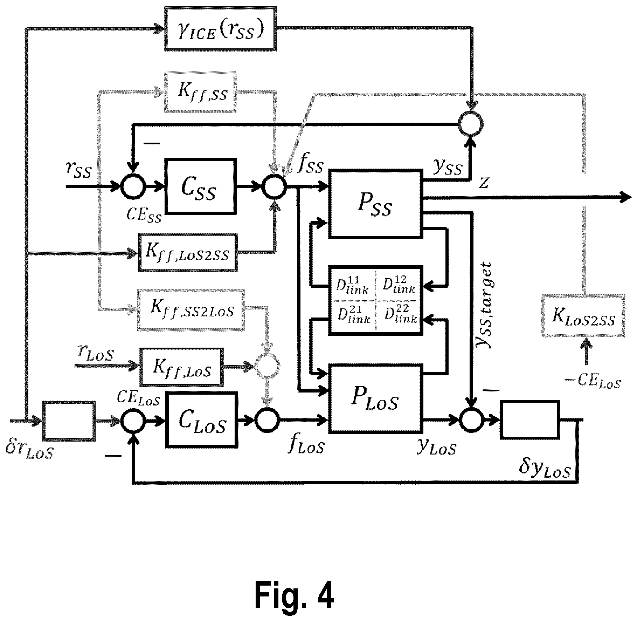

Figure 4 depicts a control diagram of a controller as part of a positioning system. The controller comprises a short stroke module feedback controller C_{SS} configured to provide closed loop feedback control for a short stroke module, represented by P_{SS}. A short stroke setpoint *rₛₛ* is input as a setpoint input of the feedback control loop. A measured position yₛₛ of the short stroke module is subtracted from the short stroke setpoint, a resulting resulting short stroke controller error signal CE_{SS} being provided as input to the short stroke module feedback controller Css.

The controller further comprises a long stroke module feedback controller C_{LoS} configured to provide closed loop feedback control for a long stroke module, represented by P_{LoS}. A differential setpoint *δr_{LoS}* long stroke setpoint is input as a setpoint input of the long stroke feedback control loop. A measured position y_{LoS} of the long stroke is subtracted from the differential setpoint, a resulting long stroke controller error signal CE_{LoS} being provided as input to the long stroke module feedback controller C_{LoS}.

A dynamic coupling between the short stroke and the long stroke is represented by a matrix Dₗᵢₙₖ, whereby D¹¹ₗᵢₙₖ represents a dynamic coupling from the short stroke to the short stroke, D¹²ₗᵢₙₖ represents a dynamic coupling between the long stroke and the short stroke, D²¹ₗᵢₙₖ represents a dynamic coupling between the short stroke and the long stroke, and D²²ₗᵢₙₖ represents a dynamic coupling between the long stroke and the long stroke.

A feedforward signal is derived from the relative position setpoint, i.e. the difference between the long stroke setpoint and the short stroke setpoint, *δr_{LoS}*. A feedforward model *K*_{*ff,LoS*2*SS*} may be used to determine the feedforward signal from the differential setpoint. The setpoint feedforward force path may typically contain a model of the actuator stiffness and damping properties. Also, other stiffness properties of e.g. hoses between LoS and SS may be taken into account. A typical first order principle LoS2SS feedforward model *K*_{*ff,LoS*2*SS*} may be represented by: ${f}_{ff , LoS 2 SS} = - \left({K}_{LoS , XY 2 SS}⋅{δr}_{LoS}+{D}_{LoS , XY 2 SS}⋅δ{\dot{r}}_{LoS}\right) ,$ Eq. 1 where *K*_{*LoS,XY*2*SS*} is the notation referring to the columns of a full stiffness matrix *K*_{*LoS*2*SS*} corresponding to the X- and Y-axis position vector components (*δr_{LoS}* may contain two components corresponding to the X- and Y-Lagging Long Stroke module, LoS, setpoint). Furthermore, *D*_{*LoS,XY*2*SS*} may be columns referring to the columns of the full damping matrix. Note that the stiffness and damping matrix refer to the stiffness and damping related forces induced on the Short Stroke module, SS (*f_{SS}*) via rigid relative motion of the LoS (*P_{LoS}*) that are transmitted via ${D}_{link}^{12}$ indicated in Figure 4.

The relative setpoint feedforward based approach as described in Eq. 1 may in essence be different from known differential sensor based stiffness (and optional damping) compensation. Known stiffness and damping compensation mechanisms may provide a substantial delay between the actual differential position motion and the sensor based one used for compensation. Together with the presence of sensor noise this may make it a non-effective dynamic compensation mechanism, in particular for damping compensation where real-time differentiation is involved.

Besides exploiting *K*_{*ff,LoS*2*SS*} for the relative setpoint based stiffness compensation the known differential sensor base stiffness compensation *K*_{*LoS*2*SS*} can still be used, however now with the LoS Controller Error, i.e. *-CE_{LoS},* as input see Figure 4. The purpose of this addition may be to still compensate low frequent LoS2SS stiffness induced disturbance forces on the SS induced by LoS relative motion deviating from *δr_{LoS}*. Furthermore, also other non-lagging LoS relative directions e.g. RZ, Z, RX and RY are now still covered.

Reverting to Figure 4, short stroke feedforward K_{ff,SS} may provide a short stroke feedforward responsive to the short stroke setpoint. The short stroke feedforward K_{ff,SS} may be based on a mass of the short stroke module to take account of the mass of the short stroke module.

A short stroke to long stroke feedforward K_{ff,SS2LoS} may provide a short stroke to long stroke feedforward responsive to the short stroke setpoint. The short stroke to long stroke feedforward K_{ff,SS2LoS} may compute the short stroke acceleration setpoint based forces required on the LoS Center of Gravity to compensate for the short stroke actuator reaction forces dumped on the Long Stroke to accelerate the Short Stroke in X and Y direction.

A long stroke feedforward K_{ff,LoS} may provide a long stroke feedforward responsive to the long stroke setpoint *r_{LoS}.* The long stroke feedforward K_{ff,LoS} may be based on a mass of the long stroke module to take account of the mass of the long stroke module.

A long stroke to short stroke feedforward K_{ff,LoS2SS} may provide a long stroke to short stroke feedforward compensating disturbance forces on the Short Stroke correlated to the relative Long Stroke to Short Stroke setpoint.

The force signal input to the short stroke plant, i.e. short stroke module is forwarded to the long stroke plant, i.e. long stroke module to form a short stroke force dump at the long stroke module.

As further depicted in Figure 4, a position path correction of the relative setpoint feedforward is provided and comprises a static model *γ_{ICE}*(*r_{SS}*)*,* mapping the relative setpoint *δr_{LoS}* towards a position correction for the Short Stroke module control loop. A purpose of this correction may be to quasi-statically compensate the induced Short Stroke module deformations induced by the locally acting parasitic disturbance forces onto the Short Stroke module (*P_{SS}*) via ${D}_{link}^{12}$*.* The SS-Z actuation concept may be a large contributor.

Accordingly, in an embodiment, the controller is further configured to generate a position path correction signal from the relative position setpoint, and to add the position path correction signal to a measured position of the short stroke module. In the above, the interest to controller error has been described, the interest to controller error reflecting a difference between the short stroke module controller error and the point of interest error, and may represent a difference between the point of interest and the measured position of the short stroke module. The interest to controller error may depend on a position of the short stroke module relative to the long stroke module, as disturbance forces on the short stroke may be dependent on the relative posittion. The above described interest to controller error (ICE) may be reduced by the position path correction signal that is determined from the relative position and added to the measured position of the short stroke module. The measured position of the short stroke module to which the position path correction signal has been added, is provided as feedback signal to the short stroke module controller.

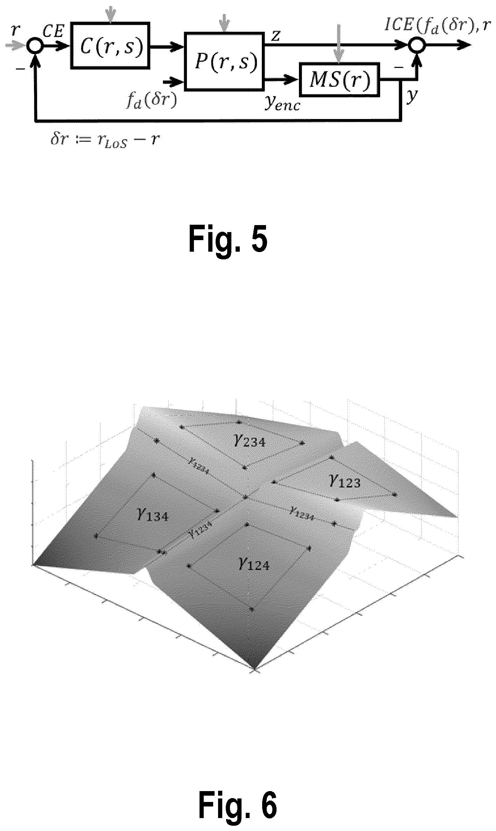

To describe the relation between the relative position setpoint *δr_{LoS}* and the required position correction on the SS control-loop, a static real-time implementable model may be used. In an embodiment, the controller is configured to determine the position path correction signal from a parametrized model. Before explaining the parametrization of the model lets first exclude the LoS control loop and zoom in on the SS control-loop only. An abstraction of the SS control-loop scenario is depicted in Figure 5, where a quasi-static situation is assumed and for shortness of notation the subscript SS to indicate signals defined related to the SS control loop, is omitted. Furthermore, the SS servo performance metric related to the SS deformations, i.e. Interest to Controller Error (ICE) is illustrated in Figure 5 as well.

Accordingly, in an embodiment, the parameterized model expresses a static interest to controller error sensitivity as a function of the relative position setpoint. The parameterized model is dependent on the short stroke setpoint of the short stroke module which may enable to take account of the differences in ICE sensitivity for different short stroke module setpoint positions.

Quasi-statically ICE can be considered as a static function of the local disturbance forces *f_{d}*, which depend on where the LoS is positioned relatively w.r.t. the SS, i.e. *δr*, and where the SS is positioned with respect e.g. the lens or the alignment and leveling sensor, i.e. r. Note that the effect of the local overdetermined disturbance forces *f_{d}*(*δr*) on the SS can quasi-statically be reflected in the output of the feedback control forces, but cannot be uniquely computed based upon them. Neither may they be accessible to be compensated by the existing actuator configuration. The effect of the resulting change on the disturbance forces on an ICE change may however be measured. This so-called static ICE sensitivity on *δr* can be measured exploiting alignment sensor for ICE-XY direction and a level sensor for ICE-Z direction. An example of ICE sensitivity ( in case of the SS-Z parasitic disturbances described above ) on the short stroke module is depicted in Figure 6. Figure 6 depicts X and Y short stroke module position along the horizontal axes, and ICE sensitivity along the vertical axis.

Following the above, in an embodiment, the substrate stage comprises a plurality of position encoders, wherein the parameterized model has been derived using a substrate stage position measurement by an alignment sensor of the substrate stage and by a level sensor of the substrate stage and an encoder position measurement by the position encoders.

Reverting to Figure 6, the position of the short stroke module may be measured by a plurality of encoders. For example, four encoders are used. Depending on a position of the short stroke actuator, a subset of three of the four encoders may be employed, namely encoders 123, 124, 134 or 234, providing 4 quadrants in which 3 of the encoders are used. Note the typical four 3-encoder quadrants used over the full SS Stage Position Measurement (SPM) (X,Y) working range may be noticeable in the ICE sensitivity. Furthermore, also transition regions / fading in-out between the four 3-encoder quadrants via full 4 encoder control may be observed in the ICE sensitivity depicted in Figure 6, at the edges between the 4 quadrants.

In an embodiment, as a compensation model parametrization of the ICE sensitivity, it is proposed to exploit the distinct encoder regions to obtain an accurate description of the actual ICE sensitivity with a limited amount of calibration points. In each encoder region experimental ICE sensitivity data grid points may be obtained exploiting at least two type of static alignment and leveling sensor measurements. That is, one reference measurement where *δr* = 0. And at least one (but optionally more) perturbation experiments, where *δr* = Δ corresponding to some constant LoS adjustments w.r.t. SS over some lagging LoS working range. Based on these experiments the ICE sensitivity can be obtained. In case of two experiments per SS grid position *i:* (*r_{X},r_{Y}*) *=* (*Yᵢ, Yᵢ*) this sensitivity can be computed as $\begin{matrix}{γ}_{124} \left({r}_{X}={Y}_{i},{r}_{Y}={Y}_{i}\right) = \\ \left[\begin{matrix}\frac{{ICE}_{X , pert} \left({δr}_{X}=Δ\right) - {ICE}_{X , ref} \left(0\right)}{Δ} & \frac{{ICE}_{X , pert} \left({δr}_{Y}=Δ\right) - {ICE}_{X , ref} \left(0\right)}{Δ} \\ \frac{{ICE}_{Y , pert} \left({δr}_{X}=Δ\right) - {ICE}_{Y , ref} \left(0\right)}{Δ} & \frac{{ICE}_{Y , pert} \left({δr}_{Y}=Δ\right) - {ICE}_{Y , ref} \left(0\right)}{Δ} \\ \frac{{ICE}_{Z , pert} \left({δr}_{X}=Δ\right) - {ICE}_{Z , ref} \left(0\right)}{Δ} & \frac{{ICE}_{Z , pert} \left({δr}_{Y}=Δ\right) - {ICE}_{Z , ref} \left(0\right)}{Δ}\end{matrix}\right] .\end{matrix}$ Eq. 2

Where the subscript notation in *γ*₁₂₄ refers to the ICE sensitivity in the encoder region where encoder 1, 2 and 4 are being used to determine the WS SS position y.

In Figure 6, some calibration points for the ICE sensitivity are indicated per encoder region by the black asterisk dots. In case of a linear dependence of ICE on *δr*, the ICE sensitivity over the total SS position range may be computed as $\begin{matrix}{γ}_{ICE} \left(r\right) = {w}_{1234} \left(r\right) ⋅ {γ}_{1234} \left(r\right) + {w}_{123} \left(r\right) ⋅ {γ}_{123} \left(r\right) + {w}_{134} \left(r\right) ⋅ {γ}_{134} \left(r\right) \\ + {w}_{124} \left(r\right) ⋅ {γ}_{124} \left(r\right) + {w}_{234} \left(r\right) ⋅ {γ}_{234} \left(r\right) .\end{matrix}$ Eq. 3

Where the functions *w*₁₂₃₄(*r*), ..., *w*₂₃₄(*r*) correspond to the current fade in fade out interpolation functions used by the SPM Measurement System ( *MS(r),* see also Figure 5 ) to transition smoothly between the 5 distinct encoder regions. The function *γ*₁₂₃₄(*r*) , ..., *γ*₂₃₄(*r*) may be implemented using 2D Look-Up Tables (LUT), where the way-points in the LUT correspond to the ICE sensitivity calibration points. In figure 6 a graphical illustration is given of Eq. 3.

Accordingly, in an embodiment, the substrate stage comprises a plurality of position encoders, wherein the parametrized model comprises an interest to controller error sensitivity submodel per subset of the position encoders, wherein the controller is configured to select a subset of the interest to controller error sensitivity submodels according to weight factors dependent on the position of the substrate support.

The overall Lagging LoS induced ICE contribution may now be predicted by the following model $\hat{ICE} \left(δr, r\right) = {γ}_{ICE} \left(r\right) ⋅ δr .$ Eq. 4

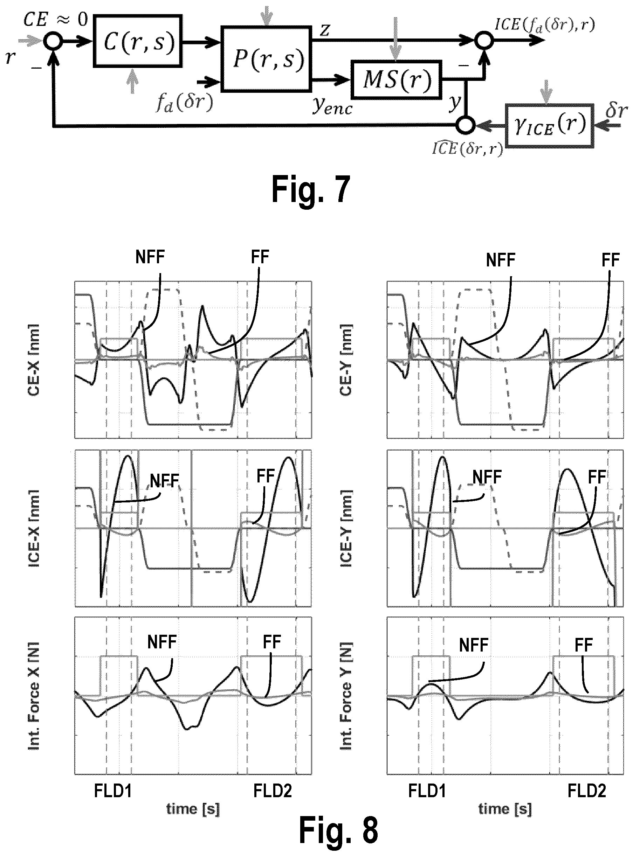

Now reconsider the SS control-loop in its quasi-static scenario, i.e. Figure 5, and apply Eq. 4 as a compensation model to the SS position used for the SS position control, i.e. as proposed in Figure 6, the scenario as is depicted in Figure 7 is obtained.

First consider no ICE compensation, i.e. the scenario as in Figure 5. Without loss of generality we can consider r = 0. Then, since *CE_{SS}* ≈ 0 *⇒ IE* ≈ *-ICE ⇒* z ≈ *ICE* ≠ r.

Now consider the $\hat{ICE}$ compensation, i.e. as in Figure 7. Then, since *CE_{SS}* ≈ 0 ⇒ *y* has changed $- \hat{ICE}$ w.r.t. no ICE compensation. This may imply that also the Point of Interest z must have changed $- \hat{ICE}$ w.r.t. no ICE compensation. Recall, that the Point of Interest without compensation was z ≈ *ICE,* then including the change with compensation one may achieve $z \approx ICE - \hat{ICE} \approx 0 =$ r *⇒ IE* ≈ 0. As a result, by the predicted interest to controller error ICE, the point of interest z is changed resulting in a lowering of the interest error IE.

In an embodiment, the controller is further configured to apply a delay compensation to the relative position setpoint, the controller comprising a long stroke actuator control loop and the controller is configured to input the delay relative position setpoint to the long stroke actuator control loop.

The relative position setpoint *δr_{LoS}* may be provided as a setpoint to the long stroke actuator, while the short stroke position setpoint is provided to the short stroke actuator. A delay compensation may be applied to the relative position setpoint *δr_{LoS}*, before injecting the relative position setpoint to the LoS control-loop. The delay compensation is depicted in Figure 4 and may be essential due to a substantial delay ( e.g. one or more SS motion control samples ) between the LoS2SS actual physical differential position change and the sensor observation of the differential position *δy_{LoS}* which is fed towards the LoS feedback controller *C_{LoS}.*

To guarantee physical synchronous motion between LoS and SS, where the LoS physical position *y_{LoS}* deviates *δr_{LoS}* w.r.t. the SS motion *y_{SS,target}* = *r_{SS}* at all times, a setpoint feedforward force, based on *r_{LoS}* (via *K_{ff,LoS}*) and *r_{SS}* (via *K*_{*ff,SS*2*LoS*})*,* see Figure 4, may be applied to the LoS *P_{LoS}* in a time synchronous way w.r.t. the setpoint feedforward force on the SS *P_{SS}.* Due to the large delay before observing the actual LoS differential position, and complying to the Controller Error definition of Long Stroke in the scheme given in Figure 4, a substantial error will be the result when comparing *δy_{LoS}* with respect to the actually realized differential position *δr_{LoS}*, while the physical Long Stroke differential motion would be perfectly according to *δr_{LoS}.* To prevent that the Long Stroke feedback controller may make faulty corrections, the relative position setpoint *δr_{LoS}* is injected into the LoS control-loop by first delaying it, as depicted in Figure 4. Typically this delay may coincide with a physical differential sensor path delay. Mostly, the IO delay effects in the controller error are actuator specifically adjusted in the timing of the setpoint feedforward force path to minimize the controller error of an actuator. De described delay of the relative position setpoint may enhance an effectiveness of the compensations explained above, i.e. the feedforward setpoint and the position path correction signal.

Accordingly, in an embodiment, the substrate stage further comprises a long stroke position sensor configured to measure a long stroke module position, wherein the delay compensation substantially compensates a sensor delay of the long stroke position sensor.

In summary, the present document presents three features that may each be applied as such, or in any suitable combination, the features being summarized below:
- wherein the controller is further configured to determine a feedforward signal from the relative position setpoint, and to feed the feedforward signal to the short stroke actuator.
- wherein the controller is further configured to generate a position path correction signal from the relative position setpoint, and to add the position path correction signal to a measured position of the short stroke actuator.
- wherein the controller is further configured to apply a delay compensation to the relative position setpoint, wherein the controller comprises a long stroke actuator control loop and wherein the controller is configured to input the delay compensated relative position setpoint to the long stroke actuator control loop.

Figure 8 depicts time diagrams based on which an effect of the three above mentioned features is illustrated. Figure 8, top row, depicts a controller error CE of the short stroke module controller along the X direction (left) and along the Y direction (right). Figure 8, center row, depicts an interest to controller error ICE of the short stroke module along the X direction (left) and along the Y direction (right). Figure 8, bottom row, depicts an internal force IF of the short stroke module along the X direction (left) and along the Y direction (right). Each one of the top, center and bottom rows in Figures 8 depicts movements associated with an exposure of two expose fields, field 1 (FLD1) and field 2 (FLD2), and movements of the short stroke module and the long stroke module in between these exposures.

Figure 8, top row, depicts the controller error CE of the short stroke module controller along the X direction (left) and along the Y direction (right), according to the prior art NFF and including the feedforward signal on the basis of the relative setpoint feedforward FF.

Figure 8, center row, depicts the interest to controller error ICE of the short stroke module along the X direction (left) and along the Y direction (right) according to the prior art NFF and including the feedforward signal on the basis of the relative setpoint feedforward FF.

Figure 8, bottom row, depicts the internal force IF of the short stroke module along the X direction (left) and along the Y direction (right) according to the prior art NFF and including the feedforward signal on the basis of the relative setpoint feedforward FF, in particular at the exposure of the expose fields.

As seen in the top, center and bottow rows of Figure 8, the controller error, the interest to controller error and the internal force of the short stroke module may be lower with the feedforward signal on the basis of the relative setpoint feedforward FF as compared to the prior art.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting.

## Claims

1. A substrate stage configured to position a substrate, the substrate stage comprising:
- a substrate support configured to support the substrate
- a short stroke actuator configured to position the substrate support,
- a long stroke actuator configured to position the short stroke actuator and the substrate support, and
- a controller configured to control the short stroke actuator according to a short stroke setpoint and to control a relative position of the long stroke actuator according to a relative position setpoint forming a difference between the short stroke setpoint of the short stroke actuator and a long stroke setpoint of the long stroke actuator, wherein the controller is further configured to determine a feedforward signal from the relative position setpoint, and to feed the feedforward signal to the short stroke actuator.

2. The substrate stage according to claim 1, wherein the short stroke setpoint and the relative position setpoint comprise position setpoints and wherein the controller is configured to determine the feedforward signal by multiplying the relative position setpoint by a stiffness matrix.

3. The substrate stage according to claim 2, wherein the stiffness matrix represents stiffness related forces induced on the short stroke actuator via movement of the long stroke actuator.

4. The substrate stage according to any one of claims 1 - 3, wherein the short stroke setpoint and the relative position setpoint comprise velocity setpoints and wherein the controller is configured to determine the feedforward signal by multiplying the relative position setpoint by a damping matrix.

5. The substrate stage according to claim 4, wherein the damping matrix represents damping related forces induced on the short stroke actuator via movement of the long stroke actuator.

6. The substrate stage according to any one of the preceding claims, wherein the controller is further configured to generate a position path correction signal from the relative position setpoint, and to add the position path correction signal to a measured position of the short stroke actuator.

7. The substrate stage according to claim 6, wherein the controller is configured to determine the position path correction signal from a parametrized model.

8. The substrate stage according to claim 7, wherein the parameterized model expresses a static interest to controller error sensitivity as a function of the relative position setpoint.

9. The substrate stage according to any one of claims 7 - 8, comprising a plurality of position encoders, wherein the parameterized model has been derived using a substrate position measurement by an alignment sensor of the substrate stage and by a level sensor of the substrate stage and an encoder position measurement by the position encoders.

10. The substrate stage according to any one of claims 7 - 9, comprising a plurality of position encoders, wherein the parametrized model comprises an interest to controller error sensitivity submodel per subset of the position encoders, wherein the controller is configured to select a subset of the interest to controller error sensitivity submodels according to weight factors dependent on the position of the substrate support.

11. The substrate stage according to any one of the preceding claims, wherein the controller is further configured to apply a delay compensation to the relative position setpoint, wherein the controller comprises a long stroke actuator control loop and wherein the controller is configured to input the delay compensated relative position setpoint to the long stroke actuator control loop.

12. The substrate stage according to claim 11, further comprising a long stroke position sensor configured to measure a long stroke actuator position, wherein the delay compensation substantially compensates a sensor delay of the long stroke position sensor.

13. A substrate stage configured to position a substrate, the substrate stage comprising:
- a substrate support configured to support the substrate
- a short stroke actuator configured to position the substrate support,
- a long stroke actuator configured to position the short stroke actuator and the substrate support, and
- a controller configured to control the short stroke actuator according to a short stroke setpoint and to control a relative position of the long stroke actuator according to a relative position setpoint forming a difference between the short stroke setpoint of the short stroke actuator and a long stroke setpoint of the long stroke actuator, wherein the controller is further configured to generate a position path correction signal fromthe relative position setpoint, and to add the position path correction signal to a measured position of the short stroke actuator.

14. A substrate stage configured to position a substrate, the substrate stage comprising:
- a substrate support configured to support the substrate
- a short stroke actuator configured to position the substrate support,
- a long stroke actuator configured to position the short stroke actuator and the substrate support, and
- a controller configured to control the short stroke actuator according to a short stroke setpoint and to control a relative position of the long stroke actuator according to a relative position setpoint forming a difference between the short stroke setpoint of the short stroke actuator and a long stroke setpoint of the long stroke actuator, wherein the controller is further configured to apply a delay compensation to the relative position setpoint, wherein the controller comprises a long stroke actuator control loop and wherein the controller is configured to input the delay compensated relative position setpoint to the long stroke actuator control loop.

15. An exposure apparatus comprising the substrate stage according to any one of the preceding claims.
